# EUROPÄISCHE PATENTSCHRIFT

(11) **EP 3 358 361 B1**
(45) Veröffentlichungstag und Bekanntmachung des Hinweises auf die Patenterteilung: **10.04.2024**
(21) Anmeldenummer: 18153135.1
(22) Anmeldetag: 24.01.2018
(51) Int. Cl.: G01R 31/54, G01R 31/396

(54) **BATTERIESYSTEM UND VERFAHREN ZUR MESSUNG VON MESSSPANNUNGEN IN EINEM BATTERIESYSTEM**
BATTERY SYSTEM AND METHOD FOR MEASURING MEASUREMENT VOLTAGES IN A BATTERY SYSTEM
SYSTÈME DE BATTERIE ET PROCÉDÉ DE MESURE DE TENSIONS DE MESURE DANS UN SYSTÈME DE BATTERIE

(30) Priorität: 07.02.2017 DE 102017201912
(43) Veröffentlichungstag der Anmeldung: 08.08.2018
(73) Patentinhaber: Robert Bosch GmbH, 70442 Stuttgart (DE)
(72) Erfinder: Thoelmann, Karsten, 71696 Moeglingen (DE); Geissinger, Volker, 74395 Mundelsheim (DE); Bergmann, Sven, 70437 Stuttgart (DE); Schneider, Joerg, 70178 Stuttgart (DE)

(56) Entgegenhaltungen:
- WO-A1-2011/036867
- US-A1- 2009 309 545
- US-A1- 2012 146 652
- US-A1- 2015 077 124

## Beschreibung

Die Erfindung betrifft zwei Verfahren zur Messung von Messspannungen in einem Batteriesystem, welches ein Batteriemodul mit mehreren seriell verschalteten Batteriezellen und eine Messschaltung zur Messung von von den Batteriezellen erzeugten Messspannungen umfasst, wobei jede Batteriezelle mit je zwei Messeingängen der Messschaltung verbunden ist, und wobei die Messspannungen an Messstrecken anliegen, welche mit je zwei Messeingängen verbunden sind.

### Stand der Technik

Es zeichnet sich ab, dass in Zukunft insbesondere in Fahrzeugen wie Elektrofahrzeugen (EV), Hybridfahrzeugen (HEV) oder Plug-In-Hybridfahrzeugen (PHEV) sowie in stationären Anlagen und in Consumer-Elektronik-Produkten vermehrt Batteriesysteme zum Einsatz kommen werden, an welche hohe Anforderungen bezüglich Zuverlässigkeit, Leistungsfähigkeit, Sicherheit und Lebensdauer gestellt werden. Für solche Anwendungen eignen sich insbesondere Batteriesysteme mit Lithium-lonen-Batteriezellen. Diese zeichnen sich unter anderem durch hohe Energiedichten, thermische Stabilität und eine äußerst geringe Selbstentladung aus.

Batteriesysteme mit Lithium-lonen-Batteriezellen weisen hohe Anforderungen bezüglich der funktionalen Sicherheit auf. Ein nicht sachgemäßer Betrieb der Batteriezellen kann zu exothermen Reaktionen bis hin zum Brand und/oder zur Entgasung führen. Zur Vermeidung dieser unerwünschten Reaktionen ist unter anderem eine sichere Überwachung der Zellspannungen der einzelnen Batteriezellen notwendig.

Aus der DE 10 2005 029 890 A1 sind ein Verfahren und eine Vorrichtung zum Bestimmen von Batteriegrößen einer Batterie bekannt. Die Batterie umfasst dabei mehrere seriell verschaltete Einzelzellen, welche mit einer Schalteinrichtung verbunden sind. Die Schalteinrichtung umfasst zwei Schalter, welche wahlweise mit Abgriffen der Einzelzellen verbindbar sind. Je nach Stellung der zwei Schalter ist eine Messung einer Spannung einer Einzelzelle oder einer Gruppe von Zellen möglich.

Die sichere Überwachung der Zellspannungen der einzelnen Batteriezellen setzt eine sichere Messdatenerfassung voraus, in der sämtliche Fehler, welche die Messung der Zellspannungen verfälschen könnten, über Diagnosefunktionen erkannt werden.

In der DE 10 2015 202 567 A1 ist ein gattungsgemäßes Batteriesystem offenbart, welches eine Batterie mit mehreren seriell verschalteten Batteriezellen und eine Messschaltung zur Messung von von den Batteriezellen bereit gestellten Spannungen umfasst. Jede Batteriezelle ist mit je zwei Messeingängen der Messschaltung verbunden und die Messeingänge sind mittels mehrerer Schalter mit zwei parallel geschalteten Messeinheiten verbindbar. Somit ist eine redundante Messung der einzelnen Spannungen in den beiden Messeinheiten möglich.

Bei einer Leitungsunterbrechung zwischen den Batteriezellen des Batteriesystems und der Messschaltung sind die gemessenen Werte der Spannungen fehlerhaft. Daher soll eine Leitungsunterbrechung frühzeitig detektiert werden. Eine Vorrichtung zur Erkennung einer Unterbrechung der Ladeleitung zwischen einem Generator und einer Batterie eines Kraftfahrzeuges ist aus der EP 1 093 205 A2 bekannt.

Die Druckschrift WO 2011/036867 A1 offenbart ein Batteriesystem, umfassend ein Batteriemodul mit mehreren seriell verschalteten Batteriezellen und eine Messschaltung zur Messung von von den Batteriezellen erzeugten Messspannungen, wobei jede Batteriezelle mittels mindestens zwei Koppelwiderständen mit je zwei Messeingängen der Messschaltung verbunden ist, und wobei die Messspannungen an Messstrecken anliegen, welche mit je zwei Messeingängen verbunden sind, wobei die Messstrecken jeweils einen mittels eines Schalters zuschaltbaren Messwiderstand umfassen.

### Offenbarung der Erfindung

Es wird ein erstes Verfahren zur Messung von Messspannungen in einem Batteriesystem vorgeschlagen, wobei das Batteriesystem ein Batteriemodul mit mehreren seriell verschalteten Batteriezellen und eine Messschaltung zur Messung von von den Batteriezellen erzeugten Messspannungen umfasst. Dabei ist jede Batteriezelle mittels mindestens zwei Koppelwiderständen mit je zwei Messeingängen der Messschaltung verbunden und die Messspannungen liegen an Messstrecken an, welche mit je zwei Messeingängen der Messschaltung verbunden sind. Die einzelnen Messstrecken sind dabei innerhalb der Messschaltung seriell verschaltet.

Die Messstrecken sind ferner mit Messeinheiten verbindbar, welche beispielsweise Vorrichtungen zur Pegelanpassung, zur Analog-Digital-Wandlung und Speichereinheiten zur Speicherung von Messwerten umfassen. Beispielsweise kann zwischen den Messstrecken und den Messeinheiten ein Multiplexer oder eine entsprechende Schaltung vorgesehen sein.

Erfindungsgemäß umfassen die Messstrecken jeweils einen mittels eines Schalters zuschaltbaren Messwiderstand. Bei geöffnetem Schalter entspricht die Messspannung zumindest annähernd einer an einer der Batteriezellen anliegenden Zellspannung. Bei geschlossenem Schalter bilden die Koppelwiderstände mit je einem Messwiderstand einen Spannungsteiler, durch welchen ein Strom fließt. Die Messspannung fällt dabei an dem Messwiderstand ab. Die Höhe der Messspannung bei geschlossenem Schalter ist über entsprechende Wahl der Koppelwiderstände und des Messwiderstandes vorgebbar.

Vorzugsweise ist die Messschaltung als integrierter Schaltkreis ausgeführt, beispielsweise als ASIC, in welchen die Messstrecken integriert sind. Auch die Messeinheiten sowie der Multiplexer können in den integrierten Schaltkreis integriert sein.

Vorteilhaft ist zwischen je zwei Messeingängen je ein Koppelkondensator vorgesehen, welcher parallel zu je einer Messstrecke geschaltet ist. Die einzelnen Koppelkondensatoren sind dabei innerhalb der Messschaltung seriell verschaltet.

Das erste Verfahren dient insbesondere zur Detektion einer Unterbrechung in einer bestimmten Zuleitung zwischen dem Batteriemodul und der Messschaltung. Das erste Verfahren umfasst dabei mehrere Schritte, welche nachfolgend erläutert werden.

In einem Schritt a) werden eine erste Messspannung an einer ersten Messstrecke und eine zweite Messspannung an einer zweiten Messstrecke bei geöffneten Schaltern gemessen. Die erste Messstrecke und die zweite Messstrecke sind dabei mit einem gemeinsamen Messeingang verbunden. Die erste Messspannung entspricht dann einer Zellspannung einer ersten Batteriezelle und die zweite Messspannung entspricht einer Zellspannung einer zweiten Batteriezelle.

In einem Schritt b) wird ein erster Schalter der ersten Messstrecke geschlossen. Daraufhin fließt ein Strom durch einen ersten Koppelwiderstand, einen zweiten Koppelwiderstand und einen ersten Messwiderstand der ersten Messstrecke. Dadurch sinkt die erste Messspannung ab und die zweite Messspannung steigt an.

In einem Schritt c) wird der erste Schalter der ersten Messstrecke wieder geöffnet. Es fließt kein Strom mehr durch den ersten Messwiderstand der ersten Messstrecke. Dadurch steigt die erste Messspannung wieder an und die zweite Messspannung sinkt wieder ab.

In einem Schritt d) wird ein zweiter Schalter der zweiten Messstrecke geschlossen. Daraufhin fließt ein Strom durch den zweiten Koppelwiderstand, einen dritten Koppelwiderstand und einen zweiten Messwiderstand der zweiten Messstrecke. Dadurch sinkt die zweite Messspannung ab und die erste Messspannung steigt an.

In einem Schritt e) wird der zweite Schalter der zweiten Messstrecke wieder geöffnet. Es fließt kein Strom mehr durch den zweiten Messwiderstand der zweiten Messstrecke. Dadurch steigt die zweite Messspannung wieder an und die erste Messspannung sinkt wieder ab.

In einem Schritt f) erfolgt ein Vergleich der gemessenen ersten Messspannung an der ersten Messstrecke mit der gemessenen zweiten Messspannung an der zweiten Messstrecke. In Abhängigkeit von dem Ergebnis dieses Vergleichs wird eine Unterbrechung in der bestimmten Zuleitung zwischen dem Batteriemodul und der Messschaltung detektiert werden.

Erfindungsgemäß wird eine Unterbrechung in der bestimmen Zuleitung zwischen dem Batteriemodul und der Messschaltung detektiert, wenn die erste Messspannung an der ersten Messstrecke von der zweiten Messspannung an der zweiten Messstrecke um einen vorgegebenen Schwellwert abweicht.

Es wird auch ein zweites Verfahren zur Messung von Messspannungen in einem Batteriesystem vorgeschlagen, wobei das Batteriesystem ein Batteriemodul mit mehreren seriell verschalteten Batteriezellen und eine Messschaltung zur Messung von von den Batteriezellen erzeugten Messspannungen umfasst. Dabei ist jede Batteriezelle mittels mindestens zwei Koppelwiderständen mit je zwei Messeingängen der Messschaltung verbunden und die Messspannungen liegen an Messstrecken an, welche mit je zwei Messeingängen der Messschaltung verbunden sind. Die einzelnen Messstrecken sind dabei innerhalb der Messschaltung seriell verschaltet.

Die Messstrecken sind ferner mit Messeinheiten verbindbar, welche beispielsweise Vorrichtungen zur Pegelanpassung, zur Analog-Digital-Wandlung und Speichereinheiten zur Speicherung von Messwerten umfassen. Beispielsweise kann zwischen den Messstrecken und den Messeinheiten ein Multiplexer oder eine entsprechende Schaltung vorgesehen sein.

Erfindungsgemäß umfassen die Messstrecken jeweils einen mittels eines Schalters zuschaltbaren Messwiderstand. Bei geöffnetem Schalter entspricht die Messspannung zumindest annähernd einer an einer der Batteriezellen anliegenden Zellspannung. Bei geschlossenem Schalter bilden die Koppelwiderstände mit je einem Messwiderstand einen Spannungsteiler, durch welchen ein Strom fließt. Die Messspannung fällt dabei an dem Messwiderstand ab. Die Höhe der Messspannung bei geschlossenem Schalter ist über entsprechende Wahl der Koppelwiderstände und des Messwiderstandes vorgebbar.

Vorzugsweise ist die Messschaltung als integrierter Schaltkreis ausgeführt, beispielsweise als ASIC, in welchen die Messstrecken integriert sind. Auch die Messeinheiten sowie der Multiplexer können in den integrierten Schaltkreis integriert sein.

Vorteilhaft ist zwischen je zwei Messeingängen je ein Koppelkondensator vorgesehen, welcher parallel zu je einer Messstrecke geschaltet ist. Die einzelnen Koppelkondensatoren sind dabei innerhalb der Messschaltung seriell verschaltet.

Das zweite Verfahren dient insbesondere zur Detektion einer Unterbrechung in einer beliebigen Zuleitung zwischen dem Batteriemodul und der Messschaltung. Das zweite Verfahren umfasst dabei mehrere Schritte, welche nachfolgend erläutert werden.

In einem Schritt a) werden Messspannungen an einer ersten Gruppe von Messstrecken und Messspannungen an einer zweiten Gruppe von Messstrecken bei geöffneten Schaltern gemessen. Die Messstrecken der ersten Gruppe sind dabei alternierend mit den Messstrecken der zweiten Gruppe angeordnet. Die Messstrecken der ersten Gruppe und die Messstrecken der zweiten Gruppe sind jeweils mit einem gemeinsamen Messeingang verbunden. Die Messspannungen entsprechen dann jeweils einer Zellspannung einer Batteriezelle.

In einem Schritt b) werden die Schalter der ersten Gruppe von Messstrecken geschlossen. Daraufhin fließt je ein Strom durch je zwei Koppelwiderstände und die Messwiderstände der ersten Gruppe von Messstrecken. Dadurch sinken die Messspannungen der ersten Gruppe von Messstrecken ab und die Messspannungen der zweiten Gruppe von Messstrecken steigen an.

In einem Schritt c) werden die Schalter der ersten Gruppe von Messstrecken wieder geöffnet. Es fließt kein Strom mehr durch die Messwiderstände der ersten Gruppe von Messstrecken. Dadurch steigen die Messspannungen der ersten Gruppe von Messstrecken wieder an und die Messspannungen der zweiten Gruppe von Messstrecken sinken wieder ab.

In einem Schritt d) werden die Schalter der zweiten Gruppe von Messstrecken geschlossen. Daraufhin fließt je ein Strom durch je zwei Koppelwiderstände und die Messwiderstände der zweiten Gruppe von Messstrecken. Dadurch sinken die Messspannungen der zweiten Gruppe von Messstrecken ab und die Messspannungen der ersten Gruppe von Messstrecken steigen an.

In einem Schritt e) werden die Schalter der zweiten Gruppe von Messstrecken wieder geöffnet. Es fließt kein Strom mehr durch die Messwiderstände der zweiten Gruppe von Messstrecken. Dadurch steigen die Messspannungen der zweiten Gruppe von Messstrecken wieder an und die Messspannungen der ersten Gruppe von Messstrecken sinken wieder ab.

In einem Schritt f) erfolgt ein Vergleich der gemessenen Messspannungen an der ersten Gruppe von Messstrecken mit den gemessenen Messspannungen an der zweiten Gruppe von Messstrecken. In Abhängigkeit von dem Ergebnis dieses Vergleichs wird eine Unterbrechung in einer beliebigen Zuleitung zwischen dem Batteriemodul und der Messschaltung detektiert.

Erfindungsgemäß wird eine Unterbrechung in einer Zuleitung zwischen dem Batteriemodul und der Messschaltung detektiert, wenn mindestens eine Messspannung an der ersten Gruppe von Messstrecken von mindestens einer Messspannung an der zweiten Gruppe von Messstrecken um einen vorgegebenen Schwellwert abweicht.

Vorzugsweise werden die Schritte des ersten Verfahrens sowie des zweiten Verfahrens, also Schritt a), Schritt b), Schritt c), Schritt d), Schritt e) und Schritt f), zyklisch wiederholt.

Bevorzugt ist bei einer zyklischen Wiederholung des Verfahrens eine fünfte Zeitspanne zwischen Schritt e) und Schritt a) länger als eine zweite Zeitspanne zwischen Schritt b) und Schritt c) und/oder länger als eine vierte Zeitspanne zwischen Schritt d) und Schritt e).

Vorzugsweise ist eine erste Zeitspanne zwischen Schritt a) und Schritt b) länger als eine zweite Zeitspanne zwischen Schritt b) und Schritt c) und/oder länger als eine vierte Zeitspanne zwischen Schritt d) und Schritt e).

Vorzugsweise ist eine dritte Zeitspanne zwischen Schritt c) und Schritt d) kürzer als eine zweite Zeitspanne zwischen Schritt b) und Schritt c) und/oder kürzer als eine vierte Zeitspanne zwischen Schritt d) und Schritt e).

Ein erfindungsgemäßes Verfahren findet vorteilhaft Verwendung in einem Elektrofahrzeug (EV), in einem Hybridfahrzeug (HEV), in einem Plug-In-Hybridfahrzeug (PHEV) in einem Consumer-Elektronik-Produkt oder in einer stationären Anlage. Unter Consumer-Elektronik-Produkten sind insbesondere Mobiltelefone, Tablet-PCs oder Notebooks zu verstehen. Eine stationäre Anlage ist beispielsweise eine Windkraftanlage.

### Vorteile der Erfindung

Die Erfindung gestattet eine verhältnismäßig schnelle Detektion einer Unterbrechung in einer Zuleitung zwischen dem Batteriemodul und der Messschaltung. Bei entsprechender Dimensionierung der elektrischen und elektronischen Bauteile ist eine Detektion einer Unterbrechung in einer Zuleitung innerhalb von etwa 20 ms möglich. Ferner ist die Detektion einer Unterbrechung in einer Zuleitung während des Betriebs der Batteriezellen möglich. Dabei werden keine negativen Auswirkungen auf die Batteriezellen sowie auf die Zellspannungen der Batteriezellen verursacht. Insbesondere muss die Detektion einer Unterbrechung in einer Zuleitung bei einem Elektrofahrzeug also nicht zwingend nach einem Fahrzyklus durchgeführt werden. Die erforderliche Messschaltung ist mit verhältnismäßig einfachen Mitteln und somit kostengünstig herstellbar. Die erfindungsgemäßen Verfahren sind robust und gestatten eine zuverlässig Detektion einer Unterbrechung in einer Zuleitung. Insbesondere kann detektiert werden, welche der Zuleitungen zwischen dem Batteriemodul und der Messschaltung. Unterbrochen ist.

### Kurze Beschreibung der Zeichnungen

Ausführungsformen der Erfindung werden anhand der Zeichnungen und der nachfolgenden Beschreibung näher erläutert.

Es zeigen:
- Figur 1: eine schematische Darstellung eines Batteriesystems,
- Figur 2: einen beispielhaften Zeitverlauf eines Messzyklus zur Messung von Messspannungen,
- Figur 3: ein beispielhafter Verlauf von Messspannungen ohne Unterbrechung einer Zuleitung und
- Figur 4: ein beispielhafter Verlauf von Messspannungen bei einer Unterbrechung einer Zuleitung.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

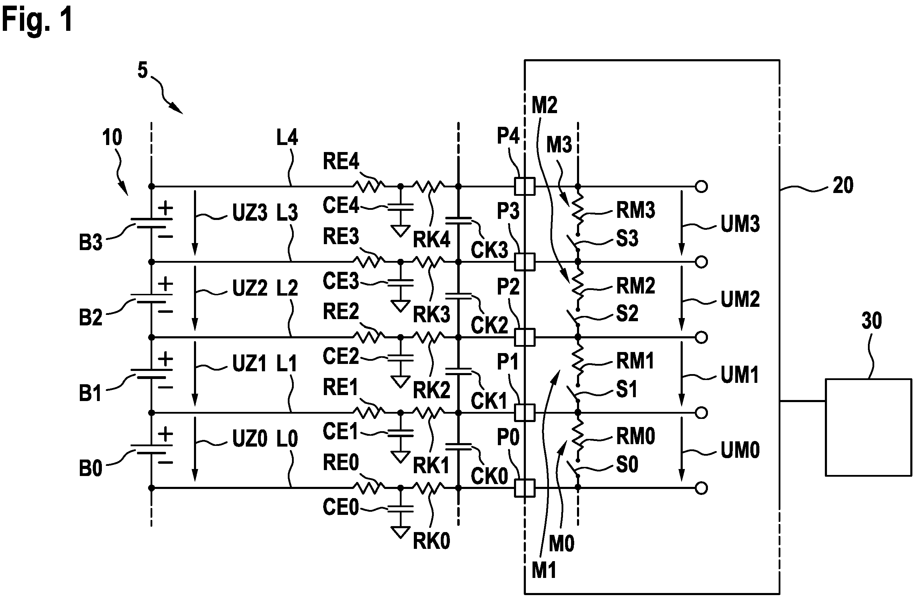

Figur 1 zeigt ein Batteriesystem 5, welches ein Batteriemodul 10 und eine Messschaltung 20 umfasst. Das Batteriemodul 10 umfasst vorliegend eine Endbatteriezelle B0, eine erste Batteriezelle B1, eine zweite Batteriezelle B2 und eine dritte Batteriezelle B3, welche seriell verschaltet sind. Das Batteriemodul 10 kann auch noch weitere, hier nicht dargestellte Batteriezellen umfassen. An der Endbatteriezelle B0 liegt eine Endzellspannung UZO an. An der ersten Batteriezelle B1 liegt eine erste Zellspannung UZ1 an. An der zweiten Batteriezelle B2 liegt eine zweite Zellspannung UZ2 an. An der dritten Batteriezelle B3 liegt eine dritte Zellspannung UZ3 an.

Die Messschaltung 20, welche vorzugsweise als integrierter Schaltkreis ausgeführt ist, weist vorliegend einen Endmesseingang P0, einen ersten Messeingang P1, einen zweiten Messeingang P2, einen dritten Messeingang P3 einen vierten Messeingang P4 auf. Die Messschaltung 20 kann auch noch weitere, hier nicht dargestellte Messeingänge umfassen. Die Anzahl der Messeingänge P0, P1, P2, P3, P4 ist dabei um eins größer als die Anzahl der Batteriezellen B0, B1, B2, B3.

Eine Endmessstrecke M0 ist mit dem Endmesseingang P0 und mit dem ersten Messeingang P1 verbunden. Die Endmessstrecke M0 umfasst einen Endmesswiderstand RM0, welcher mittels eines Endschalters S0 zuschaltbar ist. An der Endmessstrecke M0 liegt eine Endmessspannung UM0 an, welche von der Endbatteriezelle B0 erzeugt wird. Ein Endkoppelkondensator CK0 ist mit dem Endmesseingang P0 und mit dem ersten Messeingang P1 verbunden und parallel zu der Endmessstrecke M0 geschaltet.

Eine erste Messstrecke M1 ist mit dem ersten Messeingang P1 und mit dem zweiten Messeingang P2 verbunden. Die erste Messstrecke M1 umfasst einen ersten Messwiderstand RM1, welcher mittels eines ersten Schalters S1 zuschaltbar ist. An der ersten Messstrecke M1 liegt eine erste Messspannung UM1 an, welche von der ersten Batteriezelle B1 erzeugt wird. Ein erster Koppelkondensator CK1 ist mit dem ersten Messeingang P1 und mit dem zweiten Messeingang P2 verbunden und parallel zu der ersten Messstrecke M1 geschaltet.

Eine zweite Messstrecke M2 ist mit dem zweiten Messeingang P2 und mit dem dritten Messeingang P3 verbunden. Die zweite Messstrecke M2 umfasst einen zweiten Messwiderstand RM2, welcher mittels eines zweiten Schalters S2 zuschaltbar ist. An der zweiten Messstrecke M2 liegt eine zweite Messspannung UM2 an, welche von der zweiten Batteriezelle B2 erzeugt wird. Ein zweiter Koppelkondensator CK2 ist mit dem zweiten Messeingang P2 und mit dem dritten Messeingang P3 verbunden und parallel zu der zweiten Messstrecke M2 geschaltet.

Eine dritte Messstrecke M ist mit dem dritten Messeingang P3 und mit dem vierten Messeingang P4 verbunden. Die dritte Messstrecke M3 umfasst einen dritten Messwiderstand RM3, welcher mittels eines dritten Schalters S3 zuschaltbar ist. An der dritten Messstrecke M3 liegt eine dritte Messspannung UM3 an, welche von der dritten Batteriezelle B3 erzeugt wird. Ein dritter Koppelkondensator CK3 ist mit dem dritten Messeingang P3 und mit dem vierten Messeingang P4 verbunden und parallel zu der dritten Messstrecke M3 geschaltet.

Ein negativer Pol der Endbatteriezelle B0 ist über eine Endzuleitung L0, einen Endeingangswiderstand RE0 und einen Endkoppelwiderstand RK0 mit dem Endmesseingang P0 verbunden. Zwischen dem Endeingangswiderstand RE0 und dem Endkoppelwiderstand RK0 ist ein mit Masse verbundener Endeingangskondensator CE0 angeschlossen.

Ein positiver Pol der Endbatteriezelle B0 und ein negativer Pol der ersten Batteriezelle B1 sind über eine erste Zuleitung L1, einen ersten Eingangswiderstand RE1 und einen ersten Koppelwiderstand RK1 mit dem ersten Messeingang P1 verbunden. Zwischen dem ersten Eingangswiderstand RE1 und dem ersten Koppelwiderstand RK1 ist ein mit Masse verbundener erster Eingangskondensator CE1 angeschlossen.

Ein positiver Pol der ersten Batteriezelle B1 und ein negativer Pol der zweiten Batteriezelle B2 sind über eine zweite Zuleitung L2, einen zweiten Eingangswiderstand RE2 und einen zweiten Koppelwiderstand RK2 mit dem zweiten Messeingang P2 verbunden. Zwischen dem zweiten Eingangswiderstand RE2 und dem zweiten Koppelwiderstand RK2 ist ein mit Masse verbundener zweiter Eingangskondensator CE2 angeschlossen.

Ein positiver Pol der zweiten Batteriezelle B2 und ein negativer Pol der dritten Batteriezelle B3 sind über eine dritte Zuleitung L3, einen dritten Eingangswiderstand RE3 und einen dritten Koppelwiderstand RK3 mit dem dritten Messeingang P3 verbunden. Zwischen dem dritten Eingangswiderstand RE3 und dem dritten Koppelwiderstand RK3 ist ein mit Masse verbundener dritter Eingangskondensator CE3 angeschlossen.

Ein positiver Pol der dritten Batteriezelle B3 ist über eine vierte Zuleitung L4, einen vierten Eingangswiderstand RE4 und einen vierten Koppelwiderstand RK4 mit dem vierten Messeingang P4 verbunden. Zwischen dem vierten Eingangswiderstand RE4 und dem vierten Koppelwiderstand RK4 ist ein mit Masse verbundener vierter Eingangskondensator CE4 angeschlossen.

Somit ist jede der Batteriezellen B0, B1, B2, B3 mittels zwei Koppelwiderständen RK0, RK1, RK2, RK3, RK4 und zwei Eingangswiderständen RE0, RE1, RE2, RE3, RE4 mit je zwei Messeingängen P0, P1, P2, P3, P4 der Messschaltung 20 verbunden. Die Koppelwiderstände RK0, RK1, RK2, RK3, RK4, die Eingangswiderstände RE0, RE1, RE2, RE3, RE4, die Eingangskondensatoren CE0, CE1, CE2, CE3, CE4 sowie die Koppelkondensatoren CK0, CK1, CK2, CK3, sind vorliegend separat von der Messschaltung 20 angeordnet, können aber auch in die Messschaltung 20 integriert sein.

Die Messschaltung 20 ist, beispielsweise über eine Busleitung, mit einer Recheneinheit 30 verbunden. Die Recheneinheit 30 umfasst vorliegend Schaltungen zur Pegelanpassung, Analog-Digital-Wandler, Speichereinheiten sowie einen Prozessor. Die Recheneinheit 30 dient zur Verarbeitung von Messwerten, welche von der Messschaltung 20 übertragen werden.

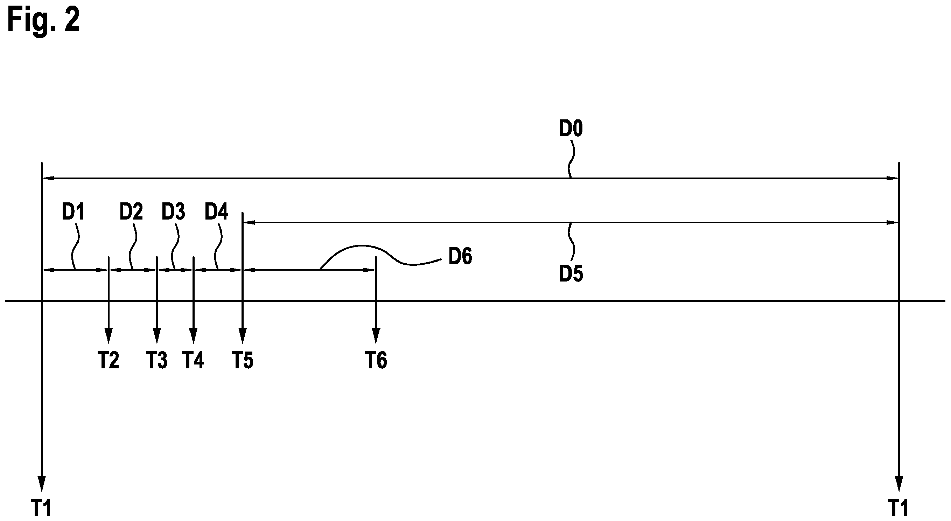

Figur 2 zeigt einen beispielhaften Zeitverlauf eines Messzyklus zur Messung von Messspannungen UM0, UM1, UM2, UM3 in einem Batteriesystem 5. Es wird davon ausgegangen, dass keine der Zuleitung L0, L1, L2, L3, L4 eine Unterbrechung aufweist.

Dabei bilden die erste Messstrecke M1 und die dritte Messstrecke M3 eine erste Gruppe. Die Endmessstrecke M0 und die zweite Messtrecke M2 bilden eine zweite Gruppe. Die erste Messstrecke M1 und die dritte Messtrecke M3 der ersten Gruppe sind alternierend mit der Endmessstrecke M0 und der zweiten Messstrecke M2 der zweiten Gruppe angeordnet. Die Messstrecken M1, M3 der ersten Gruppe und die Messstrecken M0, M2 der zweiten Gruppe sind jeweils mit einem gemeinsamen Messeingang P0, P1, P2, P3, P4 verbunden. Beispielsweise sind die erste Messtrecke M1 der ersten Gruppe und die zweite Messtrecke M2 der zweiten Gruppe mit dem zweiten Messeingang P2 verbunden.

In einem Schritt a) werden zu einem ersten Zeitpunkt T1 die Messspannungen UM1, UM3 an der ersten Gruppe von Messstrecken M1, M3 und die Messspannungen UM0, UM2 an der zweiten Gruppe von Messstrecken M0, M2 bei geöffneten Schaltern S0, S1, S2, S3 gemessen. Die Messspannungen UM0, UM1, UM2, UM3 entsprechen dabei jeweils zumindest annähernd den Zellspannungen UZ0, UZ1, UZ2, UZ3 der Batteriezellen B0, B1, B2, B3.

In einem Schritt b) werden zu einem zweiten Zeitpunkt T2 die Schalter S1, S3 der ersten Gruppe von Messstrecken M1, M3 geschlossen. Daraufhin fließt ein Strom von der ersten Batteriezelle B1 durch den ersten Eingangswiderstand RE1, den zweiten Eingangswiderstand RE2, den ersten Koppelwiderstand RK1, den zweiten Koppelwiderstand RK2 und den ersten Messwiderstand RM1 der ersten Messstrecke M1. Ebenso fließt ein Strom von der dritten Batteriezelle B3 durch den dritten Eingangswiderstand RE3, den vierten Eingangswiderstand RE4, den dritten Koppelwiderstand RK3, den vierten Koppelwiderstand RK4 und den dritten Messwiderstand RM3 der dritten Messstrecke M3.

Dadurch sinken die erste Messspannung UM1 und die dritte Messspannung UM3 der ersten Gruppe von Messstrecken M1, M3 ab. Die Endmessspannung UM0 und die zweite Messspannung UM2 der zweiten Gruppe von Messstrecken M0, M2 steigen an.

In einem Schritt c) werden zu einem dritten Zeitpunkt T3 die Schalter S1, S3 der ersten Gruppe von Messstrecken M1, M3 wieder geöffnet. Dann fließt kein Strom mehr durch die Messwiderstände RM1, RM3 der ersten Gruppe von Messstrecken M1, M3. Dadurch steigen die Messspannungen UM1, UM3 der ersten Gruppe von Messstrecken M1, M3 wieder an und die Messspannungen UM0, UM2 der zweiten Gruppe von Messstrecken M0, M2 sinken wieder ab.

In einem Schritt d) werden zu einem vierten Zeitpunkt T4 die Schalter S0, S2 der zweiten Gruppe von Messstrecken M0, M2 geschlossen. Daraufhin fließt ein Strom von der Endbatteriezelle B0 durch den ersten Eingangswiderstand RE1, den Endeingangswiderstand RE0, den ersten Koppelwiderstand RK1, den Endkoppelwiderstand RK0 und den Endmesswiderstand RM0 der Endmessstrecke M0. Ebenso fließt ein Strom von der zweiten Batteriezelle B2 durch den dritten Eingangswiderstand RE3, den zweiten Eingangswiderstand RE2, den dritten Koppelwiderstand RK3, den zweiten Koppelwiderstand RK2 und den zweiten Messwiderstand RM2 der zweiten Messstrecke M2.

Dadurch steigen die erste Messspannung UM1 und die dritte Messspannung UM3 der ersten Gruppe von Messstrecken M1, M3 an. Die Endmessspannung UM0 und die zweite Messspannung UM2 der zweiten Gruppe von Messstrecken M0, M2 sinken ab.

In einem Schritt e) werden zu einem fünften Zeitpunkt T5 die Schalter S0, S2 der zweiten Gruppe von Messstrecken M0, M2 wieder geöffnet. Dann fließt kein Strom mehr durch die Messwiderstände RM0, RM2 der zweiten Gruppe von Messstrecken M0, M2. Dadurch sinken die Messspannungen UM1, UM3 der ersten Gruppe von Messstrecken M1, M3 wieder ab und die Messspannungen UM0, UM2 der zweiten Gruppe von Messstrecken M0, M2 steigen wieder an.

In einem Schritt f) werden zu einem sechsten Zeitpunkt T6 die Messspannungen UM1, UM3 an der ersten Gruppe von Messstrecken M1, M3 und die Messspannungen UM0, UM2 an der zweiten Gruppe von Messstrecken M0, M2, die zuvor zum im Schritt a) zum ersten Zeitpunkt T1 gemessen wurden, zu der Recheneinheit 30 übertragen.

In der Recheneinheit 30 wird dann ein Vergleich der Messspannungen UM1, UM3 an der ersten Gruppe von Messstrecken M1, M3 mit den Messspannungen UM0, UM2 an der zweiten Gruppe von Messstrecken M0, M2 durchgeführt.

Anschließend beginnt ein folgender Messzyklus mit einem folgenden Schritt a) zu einem folgenden ersten Zeitpunkt T1. Der hier beschriebene Messzyklus hat vorliegend eine Zyklusdauer D0 von etwa 20 ms.

Eine erste Zeitspanne D1 zwischen dem ersten Zeitpunkt T1 und dem zweiten Zeitpunkt T2 beträgt etwa 2 ms. Eine zweite Zeitspanne D2 zwischen dem zweiten Zeitpunkt T2 und dem dritten Zeitpunkt T3 beträgt etwa 1 ms. Eine dritte Zeitspanne D3 zwischen dem dritten Zeitpunkt T3 und dem vierten Zeitpunkt T4 beträgt etwa 0,5 ms. Eine vierte Zeitspanne D4 zwischen dem vierten Zeitpunkt T4 und dem fünften Zeitpunkt T5 beträgt etwa 1 ms. Eine fünfte Zeitspanne D5 zwischen dem fünften Zeitpunkt T5 und dem ersten Zeitpunkt T1 des folgenden Zyklus beträgt etwa 15,5 ms. Eine sechste Zeitspanne D6 zwischen dem fünften Zeitpunkt T5 und dem sechsten Zeitpunkt T6 beträgt etwa 4,2 ms.

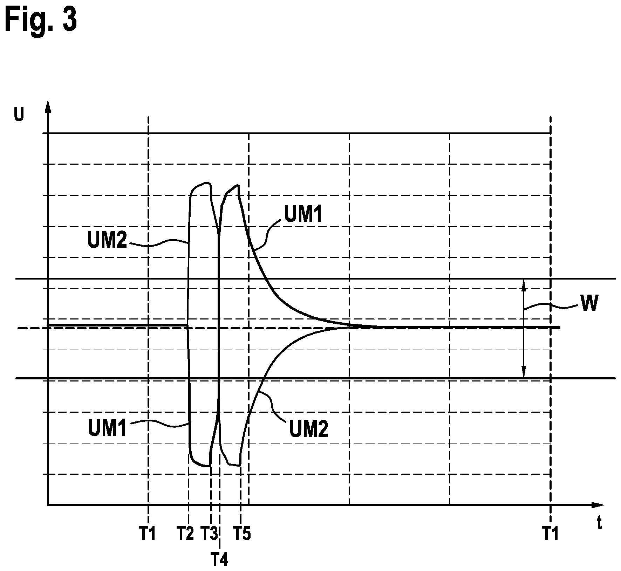

In Figur 3 ist ein beispielhafter Verlauf der ersten Messspannung UM1 und der zweiten Messspannung UM2 während des in Figur 2 gezeigten Messzyklus ohne Unterbrechung einer Zuleitung L0, L1, L2, L3, L4 dargestellt.

Nach dem Öffnen der Schalter S0, S2 der zweiten Gruppe von Messstrecken M0, M2 zum fünften Zeitpunkt T5 nähern sich die erste Messspannung UM1 und die zweite Messspannung UM2 asymptotisch einander an.

Insbesondere weichen die erste Messspannung UM1 und die zweite Messspannung UM2 zum ersten Zeitpunkt T1 des folgenden Zyklus um weniger als einen vorgegebenen Schwellwert W voneinander ab. Daraus wird detektiert, dass keine Unterbrechung der ersten Zuleitung L1, der zweiten Zuleitung L2 und der dritten Zuleitung L3 vorliegt. Aus dem Verlauf der übrigen Messspannungen UM0, UM3 kann eine Detektion einer Unterbrechung in den übrigen Zuleitungen L0, L4 erfolgen.

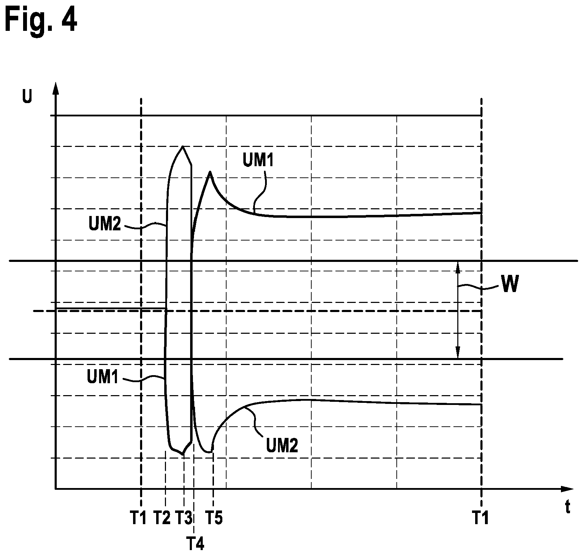

In Figur 4 ist ein beispielhafter Verlauf der ersten Messspannung UM1 und der zweiten Messspannung UM2 während eines in Figur 2 gezeigten Messzyklus bei einer Unterbrechung der zweiten Zuleitung L2 dargestellt.

Nach dem Öffnen der Schalter S0, S2 der zweiten Gruppe von Messstrecken M0, M2 zum fünften Zeitpunkt T5 nähern sich die erste Messspannung UM1 und die zweite Messspannung UM2 nur geringfügig einander an.

Insbesondere weichen die erste Messspannung UM1 und die zweite Messspannung UM2 zum ersten Zeitpunkt T1 des folgenden Zyklus um mehr als den vorgegebenen Schwellwert W voneinander ab. Daraus wird detektiert, dass eine Unterbrechung der zweiten Zuleitung L2 vorliegt.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zur Messung von Messspannungen (UMO, UM1, UM2, UM3) in einem Batteriesystem (5), umfassend ein Batteriemodul (10) mit mehreren seriell verschalteten Batteriezellen (B0, B1, B2, B3) und eine Messschaltung (20) zur Messung von von den Batteriezellen (B0, B1, B2, B3) erzeugten Messspannungen (UMO, UM1, UM2, UM3), wobei jede Batteriezelle (B0, B1, B2, B3) mittels mindestens zwei Koppelwiderständen (RKO, RK1, RK2, RK3, RK4) mit je zwei Messeingängen (P0, P1, P2, P3, P4) der Messschaltung (20) verbunden ist, und wobei die Messspannungen (UMO, UM1, UM2, UM3) an Messstrecken (M0, M1, M2, M3) anliegen, welche mit je zwei Messeingängen (P0, P1, P2, P3, P4) verbunden sind, wobei die Messstrecken (M0, M1, M2, M3) jeweils einen mittels eines Schalters (S0, S1, S2, S3) zuschaltbaren Messwiderstand (RMO, RM1, RM2, RM3) umfassen, wobei das Verfahren durch folgende Schritte gekennzeichnet ist:
a) Messen einer ersten Messspannung (UM1) an einer ersten Messstrecke (M1) und einer zweiten Messspannung (UM2) an einer zweiten Messstrecke (M2) bei geöffneten Schaltern (S0, S1, S2, S3), wobei
die erste Messstrecke (M1) und die zweite Messstrecke (M2) mit einem gemeinsamen Messeingang (P1) verbunden sind;
b) Schließen eines ersten Schalters (S1) der ersten Messstrecke (M1);
c) Öffnen des ersten Schalters (S1) der ersten Messstrecke (M1);
d) Schließen eines zweiten Schalters (S2) der zweiten Messstrecke (M2);
e) Öffnen des zweiten Schalters (S2) der zweiten Messstrecke (M2);
f) Vergleich der ersten Messspannung (UM1) an der ersten Messstrecke (M1) mit der zweiten Messspannung (UM2) an der zweiten Messstrecke (M2), wobei eine Unterbrechung in einer Zuleitung (L0, L1, L2, L3, L4) zwischen dem Batteriemodul (10) und der Messschaltung (20) detektiert wird, wenn die erste Messspannung (UM1) an der ersten Messstrecke (M1) von der zweiten Messspannung (UM2) an der zweiten Messstrecke (M2) um einen vorgegebenen Schwellwert (W) abweicht.

2. Verfahren zur Messung von Messspannungen (UMO, UM1, UM2, UM3) in einem Batteriesystem (5), umfassend ein Batteriemodul (10) mit mehreren seriell verschalteten Batteriezellen (B0, B1, B2, B3) und eine Messschaltung (20) zur Messung von von den Batteriezellen (B0, B1, B2, B3) erzeugten Messspannungen (UMO, UM1, UM2, UM3), wobei jede Batteriezelle (B0, B1, B2, B3) mittels mindestens zwei Koppelwiderständen (RKO, RK1, RK2, RK3, RK4) mit je zwei Messeingängen (P0, P1, P2, P3, P4) der Messschaltung (20) verbunden ist, und wobei die Messspannungen (UMO, UM1, UM2, UM3) an Messstrecken (M0, M1, M2, M3) anliegen, welche mit je zwei Messeingängen (P0, P1, P2, P3, P4) verbunden sind, wobei die Messstrecken (M0, M1, M2, M3) jeweils einen mittels eines Schalters (S0, S1, S2, S3) zuschaltbaren Messwiderstand (RMO, RM1, RM2, RM3) umfassen, wobei das Verfahren durch folgende Schritte gekennzeichnet ist:
a) Messen von Messspannungen (UM1, UM3) an einer ersten Gruppe von Messstrecken (M1, M3) und von Messspannungen (UMO, UM2) an einer zweiten Gruppe von Messstrecken (M0, M2)
bei geöffneten Schaltern (S0, S1, S2, S3), wobei
die Messstrecken (M1, M3) der ersten Gruppe alternierend mit den Messstrecken (M0, M2) der zweiten Gruppe angeordnet sind, und wobei die Messstrecken (M1, M3) der ersten Gruppe und die Messstrecken (M0, M2) der zweiten Gruppe jeweils mit einem gemeinsamen Messeingang (P0, P1, P2, P3, P4) verbunden sind;
b) Schließen der Schalter (S1, S3) der ersten Gruppe von Messstrecken (M1, M3);
c) Öffnen der Schalter (S1, S3) der ersten Gruppe von Messstrecken (M1, M3);
d) Schließen der Schalter (S0, S2) der zweiten Gruppe von Messstrecken (M0, M);
e) Öffnen der Schalter (S0, S2) der zweiten Gruppe von Messstrecken (M0, M2);
f) Vergleich der Messspannungen (UM1, UM3) an der ersten Gruppe von Messstrecken (M1, M3) mit den Messspannungen (UMO, UM2) an der zweiten Gruppe von Messstrecken (M0, M2),
wobei eine Unterbrechung in einer Zuleitung (L0, L1, L2, L3, L4) zwischen dem Batteriemodul (10) und der Messschaltung (20) detektiert wird, wenn mindestens eine Messspannung (UM1, UM3) an der ersten Gruppe von Messstrecken (M1, M3) von mindestens einer Messspannung (UMO, UM2) an der zweiten Gruppe von Messstrecken (M0, M2) um einen vorgegebenen Schwellwert (W) abweicht.

3. Verfahren nach einem der Ansprüche 1 oder 2, **dadurch gekennzeichnet, dass** Schritt a), Schritt b), Schritt c), Schritt d), Schritt e) und Schritt f) zyklisch wiederholt werden.

4. Verfahren nach Anspruch 3, **dadurch gekennzeichnet, dass** eine fünfte Zeitspanne (D5) zwischen Schritt e) und Schritt a) länger ist als eine zweite Zeitspanne (D2) zwischen Schritt b) und Schritt c) und/oder länger ist als eine vierte Zeitspanne (D4) zwischen Schritt d) und Schritt e).

5. Verfahren nach einem der Ansprüche 1 bis 4, **dadurch gekennzeichnet, dass** eine erste Zeitspanne (D1) zwischen Schritt a) und Schritt b) länger ist als eine zweite Zeitspanne (D2) zwischen Schritt b) und Schritt c) und/oder länger ist als eine vierte Zeitspanne (D4) zwischen Schritt d) und Schritt e).

6. Verfahren nach einem der Ansprüche 1 bis 5, **dadurch gekennzeichnet, dass** eine dritte Zeitspanne (D3) zwischen Schritt c) und Schritt d) kürzer ist als eine zweite Zeitspanne (D2) zwischen Schritt b) und Schritt c) und/oder kürzer ist als eine vierte Zeitspanne (D4) zwischen Schritt d) und Schritt e).

7. Verwendung eines Verfahrens nach einem der Ansprüche 1 bis 6 in einem Elektrofahrzeug (EV), in einem Hybridfahrzeug (HEV), in einem Plug-In-Hybridfahrzeug (PHEV), in einem Consumer-Elektronik-Produkt oder in einer stationären Anlage.

## Claims

1. Method for measuring measurement voltages (UMO, UM1, UM2, UM3) in a battery system (5), comprising a battery module (10) having a plurality of battery cells (B0, B1, B2, B3) connected in series and a measurement circuit (20) for measuring measurement voltages (UMO, UM1, UM2, UM3) produced by the battery cells (B0, B1, B2, B3), wherein each battery cell (B0, B1, B2, B3) is connected in each case to two measurement inputs (P0, P1, P2, P3, P4) of the measurement circuit (20) by means of at least two coupling resistors (RKO, RK1, RK2, RK3, RK4), and wherein the measurement voltages (UMO, UM1, UM2, UM3) are present across measurement sections (M0, M1, M2, M3) which are connected in each case to two measurement inputs (P0, P1, P2, P3, P4), wherein the measurement sections (M0, M1, M2, M3) each comprise a measurement resistor (RMO, RM1, RM2, RM3) which is able to be switched on by means of a switch (S0, S1, S2, S3), wherein the method is **characterized by** the following steps:
a) measuring a first measurement voltage (UM1) across a first measurement section (M1) and a second measurement voltage (UM2) across a second measurement section (M2) with switches (S0, S1, S2, S3) open, wherein
the first measurement section (M1) and the second measurement section (M2) are connected to a common measurement input (P1);
b) closing a first switch (S1) of the first measurement section (M1);
c) opening the first switch (S1) of the first measurement section (M1);
d) closing a second switch (S2) of the second measurement section (M2);
e) opening the second switch (S2) of the second measurement section (M2);
f) comparing the first measurement voltage (UM1) across the first measurement section (M1) with the second measurement voltage (UM2) across the second measurement section (M2), wherein an interruption in a supply line (L0, L1, L2, L3, L4) between the battery module (10) and the measurement circuit (20) is detected if the first measurement voltage (UM1) across the first measurement section (M1) deviates from the second measurement voltage (UM2) across the second measurement section (M2) by a predefined threshold value (W).

2. Method for measuring measurement voltages (UMO, UM1, UM2, UM3) in a battery system (5), comprising a battery module (10) having a plurality of battery cells (B0, B1, B2, B3) connected in series and a measurement circuit (20) for measuring measurement voltages (UMO, UM1, UM2, UM3) produced by the battery cells (B0, B1, B2, B3), wherein each battery cell (B0, B1, B2, B3) is connected in each case to two measurement inputs (P0, P1, P2, P3, P4) of the measurement circuit (20) by means of at least two coupling resistors (RKO, RK1, RK2, RK3, RK4), and wherein the measurement voltages (UMO, UM1, UM2, UM3) are present across measurement sections (M0, M1, M2, M3) which are connected in each case to two measurement inputs (P0, P1, P2, P3, P4), wherein the measurement sections (M0, M1, M2, M3) each comprise a measurement resistor (RMO, RM1, RM2, RM3) which is able to be switched on by means of a switch (S0, S1, S2, S3), wherein the method is **characterized by** the following steps:
a) measuring measurement voltages (UM1, UM3) across a first group of measurement sections (M1, M3) and measurement voltages (UMO, UM2) across a second group of measurement sections (M0, M2) with switches (S0, S1, S2, S3) open, wherein
the measurement sections (M1, M3) of the first group are arranged so as to alternate with the measurement sections (M0, M2) of the second group, and wherein the measurement sections (M1, M3) of the first group and the measurement sections (M0, M2) of the second group are respectively connected to a common measurement input (P0, P1, P2, P3, P4) ;
b) closing the switches (S1, S3) of the first group of measurement sections (M1, M3);
c) opening the switches (S1, S3) of the first group of measurement sections (M1, M3);
d) closing the switches (S0, S2) of the second group of measurement sections (M0, M);
e) opening the switches (S0, S2) of the second group of measurement sections (M0, M2);
f) comparing the measurement voltages (UM1, UM3) across the first group of measurement sections (M1, M3) with the measurement voltages (UMO, UM2) across the second group of measurement sections (M0, M2),
wherein an interruption in a supply line (L0, L1, L2, L3, L4) between the battery module (10) and the measurement circuit (20) is detected if at least one measurement voltage (UM1, UM3) across the first group of measurement sections (M1, M3) deviates from at least one measurement voltage (UMO, UM2) across the second group of measurement sections (M0, M2) by a predefined threshold value (W).

3. Method according to either of Claims 1 and 2, **characterized in that** step a), step b), step c), step d), step e) and step f) are repeated cyclically.

4. Method according to Claim 3, **characterized in that** a fifth period of time (D5) between step e) and step a) is longer than a second period of time (D2) between step b) and step c) and/or is longer than a fourth period of time (D4) between step d) and step e).

5. Method according to one of Claims 1 to 4, **characterized in that** a first period of time (D1) between step a) and step b) is longer than a second period of time (D2) between step b) and step c) and/or is longer than a fourth period of time (D4) between step d) and step e).

6. Method according to one of Claims 1 to 5, **characterized in that** a third period of time (D3) between step c) and step d) is shorter than a second period of time (D2) between step b) and step c) and/or is shorter than a fourth period of time (D4) between step d) and step e).

7. Use of a method according to one of Claims 1 to 6 in an electric vehicle (EV), in a hybrid vehicle (HEV), in a plug-in hybrid vehicle (PHEV), in a consumer electronics product or in a stationary installation.

## Revendications

1. Procédé de mesure de tensions de mesure (UMO, UM1, UM2, UM3) dans un système de batterie (5), comprenant un module de batterie (10) avec plusieurs cellules de batterie (B0, B1, B2, B3) connectées en série et un circuit de mesure (20) pour mesurer des tensions de mesure (UMO, UM1, UM2, UM3) générées par les cellules de batterie (B0, B1, B2, B3), chaque cellule de batterie (B0, B1, B2, B3) étant connectée au moyen d'au moins deux résistances de couplage (RKO, RK1, RK2, RK3, RK4) à deux entrées de mesure (P0, P1, P2, P3, P4) du circuit de mesure (20), et les tensions de mesure (UMO, UM1, UM2, UM3) étant appliquées à des sections de mesure (M0, M1, M2, M3) qui sont connectées chacune à deux entrées de mesure (P0, P1, P2, P3, P4), les sections de mesure (M0, M1, M2, M3) comprenant chacune une résistance de mesure (RMO, RM1, RM2, RM3) apte à être connectée au moyen d'un commutateur (S0, S1, S2, S3), le procédé étant **caractérisé par** les étapes suivantes :
a) mesure d'une première tension de mesure (UM1) sur une première section de mesure (M1) et d'une deuxième tension de mesure (UM2) sur une deuxième section de mesure (M2) avec des commutateurs (S0, S1, S2, S3) ouverts,
la première section de mesure (M1) et la deuxième section de mesure (M2) étant connectées à une entrée de mesure commune (P1) ;
b) fermeture d'un premier commutateur (S1) de la première section de mesure (M1) ;
c) ouverture du premier commutateur (S1) de la première section de mesure (M1) ;
d) fermeture d'un deuxième commutateur (S2) de la deuxième section de mesure (M2) ;
e) ouverture du deuxième commutateur (S2) de la deuxième section de mesure (M2) ;
f) comparaison de la première tension de mesure (UM1) sur la première section de mesure (M1) avec la deuxième tension de mesure (UM2) sur la deuxième section de mesure (M2), une interruption dans une ligne d'alimentation (L0, L1, L2, L3, L4) entre le module de batterie (10) et le circuit de mesure (20) étant détectée lorsque la première tension de mesure (UM1) sur la première section de mesure (M1) s'écarte de la deuxième tension de mesure (UM2) sur la deuxième section de mesure (M2) d'une valeur de seuil (W) prédéfinie.

2. Procédé de mesure de tensions de mesure (UMO, UM1, UM2, UM3) dans un système de batterie (5), comprenant un module de batterie (10) avec plusieurs cellules de batterie (B0, B1, B2, B3) connectées en série et un circuit de mesure (20) pour mesurer des tensions de mesure (UMO, UM1, UM2, UM3) générées par les cellules de batterie (B0, B1, B2, B3), chaque cellule de batterie (B0, B1, B2, B3) étant connectée au moyen d'au moins deux résistances de couplage (RKO, RK1, RK2, RK3, RK4) à deux entrées de mesure (P0, P1, P2, P3, P4) du circuit de mesure (20), et les tensions de mesure (UMO, UM1, UM2, UM3) étant appliquées à des sections de mesure (M0, M1, M2, M3) qui sont connectées chacune à deux entrées de mesure (P0, P1, P2, P3, P4), les sections de mesure (M0, M1, M2, M3) comprenant chacune une résistance de mesure (RMO, RM1, RM2, RM3) apte à être connectée au moyen d'un commutateur (S0, S1, S2, S3), le procédé étant **caractérisé par** les étapes suivantes :
a) mesure de tensions de mesure (UM1, UM3) sur un premier groupe de sections de mesure (M1, M3) et de tensions de mesure (UMO, UM2) sur un deuxième groupe de sections de mesure (M0, M2) avec des commutateurs (S0, S1, S2, S3) ouverts,
les sections de mesure (M1, M3) du premier groupe étant agencées en alternance avec les sections de mesure (M0, M2) du deuxième groupe, et les sections de mesure (M1, M3) du premier groupe et les sections de mesure (M0, M2) du deuxième groupe étant chacune reliées à une entrée de mesure commune (P0, P1, P2, P3, P4) ;
b) fermeture des commutateurs (S1, S3) du premier groupe de sections de mesure (M1, M3) ;
c) ouverture des commutateurs (S1, S3) du premier groupe de sections de mesure (M1, M3) ;
d) fermeture des commutateurs (S0, S2) du deuxième groupe de sections de mesure (M0, M) ;
e) ouverture des commutateurs (S0, S2) du deuxième groupe de sections de mesure (M0, M2) ;
f) comparaison des tensions de mesure (UM1, UM3) sur le premier groupe de sections de mesure (M1, M3) avec les tensions de mesure (UMO, UM2) sur le deuxième groupe de sections de mesure (M0, M2),
une interruption dans une ligne d'alimentation (L0, L1, L2, L3, L4) entre le module de batterie (10) et le circuit de mesure (20) étant détectée lorsqu'au moins une tension de mesure (UM1, UM3) sur le premier groupe de sections de mesure (M1, M3) s'écarte d'au moins une tension de mesure (UMO, UM2) sur le deuxième groupe de sections de mesure (M0, M2) d'une valeur de seuil prédéterminée (W).

3. Procédé selon l'une des revendications 1 ou 2, **caractérisé en ce que** l'étape a), l'étape b), l'étape c), l'étape d), l'étape e) et l'étape f) sont répétées de manière cyclique.

4. Procédé selon la revendication 3, **caractérisé en ce que**
une cinquième période de temps (D5) entre l'étape e) et l'étape a) est plus longue qu'une deuxième période de temps (D2) entre l'étape b) et l'étape c) et/ou est plus longue qu'une quatrième période de temps (D4) entre l'étape d) et l'étape e).

5. Procédé selon l'une des revendications 1 à 4, **caractérisé en ce qu'**une première période de temps (D1) entre l'étape a) et l'étape b) est plus longue qu'une deuxième période de temps (D2) entre l'étape b) et l'étape c) et/ou est plus longue qu'une quatrième période de temps (D4) entre l'étape d) et l'étape e).

6. Procédé selon l'une des revendications 1 à 5, **caractérisé en ce qu'**une troisième période de temps (D3) entre l'étape c) et l'étape d) est plus courte qu'une deuxième période de temps (D2) entre l'étape b) et l'étape c) et/ou est plus courte qu'une quatrième période de temps (D4) entre l'étape d) et l'étape e).

7. Utilisation d'un procédé selon l'une des revendications 1 à 6 dans un véhicule électrique (EV), dans un véhicule hybride (HEV), dans un véhicule hybride rechargeable (PHEV), dans un produit électronique grand public ou dans une installation fixe.
